# EUROPÄISCHE PATENTSCHRIFT

(11) **EP 3 172 542 B1**
(45) Veröffentlichungstag und Bekanntmachung des Hinweises auf die Patenterteilung: **12.09.2018**
(21) Anmeldenummer: 15734414.4
(22) Anmeldetag: 10.07.2015
(51) Int. Cl.: G01J 3/10, G01J 3/42, G01J 3/50, G01J 1/42, H01L 51/52

(54) **ANORDNUNG ZUR ORTS- UND WELLENLÄNGENAUFGELÖSTEN ERFASSUNG VON LICHTSTRAHLUNG, DIE VON MINDESTENS EINER OLED ODER LED EMITTIERT WIRD**
ARRANGEMENT FOR SPATIALLY RESOLVED AND WAVELENGTH-RESOLVED DETECTION OF LIGHT RADIATION EMITTED FROM AT LEAST ONE OLED OR LED
ENSEMBLE DE DÉTECTION AVEC RÉSOLUTION DE POSITION ET DE LONGUEUR D'ONDE D'UN RAYONNEMENT LUMINEUX QUI EST ÉMIS PAR AU MOINS UNE OLED OU UNE LED

(30) Priorität: 25.07.2014 DE 102014214721
(43) Veröffentlichungstag der Anmeldung: 31.05.2017
(73) Patentinhaber: Fraunhofer-Gesellschaft zur Förderung der angewandten Forschung e.V., 80686 München (DE)
(72) Erfinder: DANZ, Norbert, 07743 Jena (DE); WÄCHTER, Christoph, 07743 Jena (DE)
(74) Vertreter: Pfenning, Meinig & Partner mbB
(86) Internationale Anmeldenummer: PCT/EP2015/065834
(87) Internationale Veröffentlichungsnummer: WO 2016/012276

(56) Entgegenhaltungen:
- EP-A2- 1 739 764
- WO-A1-2014/181695
- WO-A2-2010/060915
- DE-A1-102006 039 171
- DE-A1-102009 037 185
- DE-A1-102012 109 135
- JP-A- 2012 204 240
- US-A- 5 780 174

## Beschreibung

Die Erfindung betrifft eine Anordnung zur orts- und wellenlängenaufgelösten Erfassung von Lichtstrahlung, die von mindestens einer OLED oder LED emittiert wird. Dabei kann mindestens eine Probe analytisch untersucht werden.

Dabei soll beachtet werden, dass mit einer spontan und breitbandig emittierenden Lichtquelle eine definierte Dispersion der Emission (d.h. spektrale Winkelabhängigkeit) so aufgeprägt werden kann, dass diese ohne klassischen Spektralapparat für spektroskopische Untersuchungen verwendet werden kann.

Dafür kommen insbesondere LED oder OLED in Frage. Speziell für OLED oder LED ist es das Ziel, das Lambertsche Strahlungsfeld dieser Lichtquellen so zu beeinflussen, dass die OLED oder LED als messtechnische Lichtquelle qualifiziert sind.

Bisher ist keine Lösung für dieses Problem bekannt. Offensichtlich kann natürlich eine klassische (Punkt)Lichtquelle mit einem Monochromator kombiniert werden. Alternativ wäre es denkbar, auch die Funktionalität dieses Monochromators in ein (komplexes) optisches Element zu integrieren und mit einer klassischen Lichtquelle zu kombinieren. Dabei treten aber Intensitätsverluste auf und es kann mit lediglich einer Wellenlänge oder einem sehr begrenzten Wellenlängenspektrum gearbeitet werden.

OLED und LED sind in der vergangenen Dekade zu kommerziellen Lichtquellen entwickelt worden. Dabei ist die Anwendung von OLED im Wesentlichen auf Displays in kleinen Abmessungen für Mobilfunkgeräte sowie großen Formaten als TV und die allgemeine Beleuchtung beschränkt. Hierfür werden effiziente Bauelemente im Bereich 60..80 lm/W kommerziell angeboten. Sie sind aber noch nicht am Markt etabliert. Daneben werden Backlights oder selbst leuchtende Beschilderungen als Anwendungsgebiete genannt. Mit fortschreitender Markteinführung der OLED werden zukünftig auch andere - von den beiden oben genannten abweichende - Anwendungen interessant. Dabei wird gewöhnlich auf die Homogenität des Strahlungsfelds (über der Fläche oder dem Winkel der emittierten Strahlung) abgezielt.

Seit der (akademischen) Verfügbarkeit von OLED werden diese auch für sensorische Aufgaben eingesetzt. Ziel dieser Arbeiten ist eine weitgehende Integration von Lichtquelle und optischem Sensor. Dabei werden zum Teil auch organische Fotodetektoren vorgeschlagen, um eine vollständige Integration des optischen Systems zu ermöglichen. Organische Fotodetektoren stellen jedoch zusätzliche technologische Anforderungen und Risiken. Sie limitieren aufgrund des im Vergleich zu anorganischen Detektoren schlechteren Verhältnisses von Messsignal zu Untergrund (Signal-Rauschverhältnis) die Leistungsfähigkeit derartiger Systeme. Die Nutzung von OLED als Lichtquelle kann in unterschiedlicher Weise erfolgen. Vielfältig wird sie zur Fluoreszenzanregung genutzt, wobei gewöhnlich ein "Sandwich" aus Lichtquelle, Probe, Filtern, und Detektor zusammengesetzt wird. Problematisch ist dabei das große Winkelspektrum der emittierten Strahlung. Dabei wird Lichtstrahlung mit den jeweiligen Wellenlängen des emittierten Spektrums in die unterschiedlichsten undefinierten Richtungen emittiert.

Eine Sonderrolle bei den Fluoreszenzansätzen nehmen die lebensdauerbasierten Systeme ein, bei denen nur die Abklingzeit eines sensorischen Farbstoffs ausgewertet wird. Hinsichtlich markierungsfrei messender Ansätze ist vor allem die SPR in der Literatur beschrieben. Dabei wird auch hier das breite (Winkel)Spektrum der Emission durch eine Faser oder auch durch zusätzliche mikrooptische Elemente eingeschränkt. Eine gezielte Modifikation des Strahlungsfelds, um für die (markierungsfreie) Sensorik ideale Charakteristika der Lichtquelle zu erreichen, ist nicht bekannt
So betrifft US 5,780,174 A einen mikrooptischen Resonatorvorrichtung.

Ein Verfahren und eine Vorrichtung zum Ermitteln eines Winkels eines Messobjektes gegenüber einer Detektionsvorrichtung mittels organischer Leuchtdiode sind in DE 10 2006 039 171 A1 beschrieben.

DE 10 2009 037 185 A1 betrifft eine organische Leuchtdiode.

Eine LED bei der eine Elektrode ein Mehrschichtaufbau aus amorphem Kohlenstoff ist, ist aus EP 1 739 764 A2 bekannt.

Es ist daher Aufgabe der Erfindung, Möglichkeiten anzugeben mit denen bei breitbandig Lichtstrahlung emittierenden OLED oder LED die Lichtstrahlung wellenlängenaufgelöst mit definierten Winkeln emittiert und diese Lichtstrahlung wellenlängenspezifisch für die sensorische Bestimmung von Messsignalen genutzt werden kann.

Erfindungsgemäß wird diese Aufgabe mit einer Anordnung, die die Merkmale des Anspruchs 1 aufweist, gelöst. Vorteilhafte Ausgestaltungen der Erfindung können mit in untergeordneten Ansprüchen bezeichneten Merkmalen realisiert werden.

Bei der erfindungsgemäßen Anordnung zur orts- und wellenlängenaufgelösten Erfassung von Lichtstrahlung, die von mindestens einer OLED oder LED emittiert wird, ist zwischen einer Elektrode einer OLED oder LED ein Mehrschichtsystem, das mit alternierend übereinander ausgebildeten Schichten aus einem Material mit höherem und niedrigeren optischen Brechungsindex n gebildet ist, und einem Substrat angeordnet ist, vorhanden. Von der mindestens einen OLED (1) oder LED wird Lichtstrahlung mit mehreren unterschiedlichen Wellenlängen λ1, λ2, λ3, ...λn emittiert und tritt so aus dem Mehrschichtsystem aus, dass Lichtstrahlung mit unterschiedlichen Wellenlängen λ1, λ2, λ3, ...λn mit definierten Winkeln austritt, wobei die mittels des Mehrschichtsystems definiert dispergierte Lichtstrahlung nach mindestens einfacher Brechung an einem optischen Element oder nach Reflexion an einer Schicht oder einem Schichtsystem eines Sensors auf mindestens ein zur orts- aufgelösten Erfassung von Lichtstrahlung ausgebildetes Detektorarray auftrifft. Dabei erfolgt eine einfache optische Brechung wenn die aus dem Mehrschichtsystem austretende emittierte Lichtstrahlung aus einem optischen Element, das unmittelbar über dem Mehrschichtsystem angeordnet ist, austritt. Also das Mehrschichtsystem unmittelbar auf einer Oberfläche eines optisches Elements ausgebildet ist oder das optische Element mittels einer Immersionsflüssigkeit optisch daran gekoppelt ist.

Aufgrund der Tatsache, dass die unterschiedlichen Wellenlängen λ1, λ2, λ3, ...λn unter verschiedenen Winkeln emittiert werden, führt diese ortsaufgelöste Erfassung zu einer wellenlängenaufgelösten Messung.

Dabei kann das jeweilige Mehrschichtsystem so ausgebildet sein, dass Lichtstrahlung mit größerer Wellenlänge mit einem größeren Winkel in Bezug zur Normalen der Oberfläche eines Substrats einer OLED oder LED austritt, als Lichtstrahlung mit kleinerer Wellenlänge oder umgekehrt. Dabei kann eine Abhängigkeit der Winkel von den jeweiligen Wellenlängen eingehalten werden, so dass die Winkel mit kleiner oder größer werdenden Wellenlängen jeweils entsprechend der gewünschten sich analog veränderten Wellenlängen verändert werden.

Ein optisches Element, an dem eine optische Brechung erfolgt, kann eine optische Linse oder ein Prisma sein. Ein solches optisches Element kann integraler Bestandteil eines Substrats der OLED oder der LED, mittels einer Immersionsflüssigkeit mit dem Substrat verbunden oder in einem Abstand zum Substrat mit einem dazwischen vorhandenen Spalt angeordnet sein.

Ein optisches Element kann aber auch eine auf der Oberfläche des Substrates, an der die von einer OLED oder LED emittierte Lichtstrahlung austritt, als eine mikrooptische Oberflächenstruktur ausgebildet oder dort vorhanden sein. Damit kann eine weitergehende Dispersion, bevorzugt eine Aufspreizung der Lichtstrahlung mit den unterschiedlichen Wellenlängen λ1, λ2, λ3, ...λn, erreicht werden, so dass die Abstände von Auftreffpositionen, insbesondere auf einzelne Detektoren des Detektorarrays vergrößert werden können.

Das Detektorarray sollte so angeordnet und/oder ausgebildet sein, das Lichtstrahlung mit einer spezifischen Wellenlänge λ1, λ2, λ3, ...oder λn jeweils auf mindestens ein entsprechend angeordnetes definiertes Detektorelement (Pixel) des Detektorarrays auftrifft, mit dem die jeweilige Intensität von Lichtstrahlung bekannter Wellenlängen messbar ist. Dabei kann Lichtstrahlung einer Wellenlänge λx auf ein einziges Detektorelement auftreffen und damit die Intensität der Lichtstrahlung für diese Wellenlänge λx mit dem einen Detektorelement bestimmt werden. Dies kann für eine Wellenlänge λx aber auch mit einer Gruppe nebeneinander angeordneter Detektorelemente erreicht werden, die entsprechend nah genug nebeneinander und trotzdem so angeordnet sind, dass auf diese Detektorelemente keine Lichtstrahlung mit anderen Wellenlängen auftrifft. Eine Gruppe von Detektorelementen kann beispielsweise auch eine Reihenanordnung von Detektorelementen sein.

Da das Strahlungsfeld einer hier vorgeschlagenen Lichtquellen OLED oder LED (rotations)symmetrisch zur Oberflächennormalen der Lichtquelle ist, kann auch ein zweiter Strahlengang mit einem zweiten Detektorarray genutzt werden, das dann bevorzugt für eine Referenzmessung nutzbar ist. Dies gestattet ebenso die gleichzeitige Messung mehrerer Proben. Dabei kann bei der Referenzmessung auf die Anordnung einer Probe im Strahlengang der dispersiv in mehrere Wellenlängen mit unterschiedlichen Winkeln aufgespaltenen Lichtstrahlung oder auch an einem SPR- oder BSW-Sensor verzichtet werden. Zwei Detektorarrays sollten winkelsymmetrisch in Bezug zu einer Achse oder Ebene angeordnet sein.

Bei der Erfindung können als solche bereits bekannte SPR-Sensoren oder BSW-Sensoren eingesetzt werden. Bei der Erfindung kann mindestens ein SPR- oder BSW-Sensor mit einer Schicht oder einem Dünnschichtsystem vorhanden sein, an dem die Lichtstrahlung mit den unterschiedlichen Wellenlängen λ1, λ2, λ3, ...λn reflektiert und danach auf ein Detektorarray gerichtet wird.

Durch die Anordnung eines dielektrischen Mehrschichtsystems, also eines Systems aus optisch hoch- und niedrigbrechenden Schichten, die übereinander und zwischen dem für die Lichtstrahlung transparenten Substrat und einer Lichtstrahlung emittierenden Fläche (z.B. der Anode) angeordnet sind, bleibt das aktive elektrische System einer OLED oder LED unverändert. Dadurch wird eine optische Kavität ausgebildet, die durch die (metallische) Kathode auf der einen und den dielektrischen Schichtstapel auf der anderen Seite bei einer OLED gebildet werden kann.

Bei einer LED oder OLED die zwei für die emittierte Lichtstrahlung transparente Elektroden aufweist, kann ein zweites Mehrschichtsystem eingesetzt werden, durch das von dieser Elektrode emittierte Lichtstrahlung ebenfalls, wie vorab beschrieben, auf mindestens ein weiteres Detektorarray gerichtet werden kann. Das zweite Mehrschichtsystem kann, wie das erste Mehrschichtsystem ausgebildet sein. Es kann aber auch aus unterschiedlichen Materialien für die optisch höher und niedriger brechenden Schichten und/oder mit vom ersten Mehrschichtsystem abweichenden Schichtdicken der einzelnen das zweite Mehrschichtsystem bildenden Schichten, im Vergleich mit denen des ersten Mehrschichtsystems durch das von der jeweils anderen Elektrode emittierte Lichtstrahlung austritt, gebildet sein. Bei zwei verschieden ausgebildeten Mehrschichtsystemen, die an derselben Lichtquelle genutzt werden, können dann eine unterschiedliche Dispersion, bei der Lichtstrahlung unterschiedlicher Wellenlängen λx mit unterschiedlichen Winkeln emittiert werden, genutzt werden. Dies kann dann gleichzeitig für unterschiedliche Untersuchungen, beispielsweise für verschiedene Analysen an unterschiedlichen oder gleichen Proben ausgenutzt werden.

Bei der Erfindung besteht die Möglichkeit, die emittierte Lichtstrahlung durch eine für die Lichtstrahlung zumindest teilweise transparente Probe auf ein Detektorarray zu richten. Die Probe kann dabei bevorzugt flüssig sein und zu detektierende Analyten enthalten.

Nachfolgend soll die Erfindung anhand von Beispielen näher erläutert werden. Dabei können technische Merkmale verschiedener Beispiele unabhängig vom jeweiligen Beispiel, bei dem sie beschrieben sind, auch bei anderen Beispielen eingesetzt werden.

Dabei zeigen:
Figur 1 in schematischer Form ein Beispiel einer herkömmlichen OLED und ein Beispiel mit einem Mehrschichtsystem sowie Bilder von in Abhängigkeit der jeweiligen Wellenlänge veränderte Winkel mit denen Lichtstrahlen emittiert werden können;
Figur 2 in schematischer Form ein Beispiel einer OLED mit Mehrschichtsystem und mikrooptischer Oberflächenstruktur an einem Substrat;
Figur 3a u. b Beispiele einer erfindungsgemäßen Anordnung mit jeweils einem optischen Element, an dem eine Brechung von emittierter und dispergierter Lichtstrahlung erfolgt;
Figur 4 Bilder von dispergierter Lichtstrahlung nach einer Reflexion an einem SPR-Sensor (links) und einem BSR-Sensor (rechts);
Figur 5 ein Beispiel in schematischer Darstellung bei dem dispergierte Lichtstrahlung aus einer OLED in einen für die Lichtstrahlung transparenten Körper eintritt, der Bestandteil eines SPR- oder BSW-Sensors ist und der Körper die Strahlführung beeinflussende Oberflächen aufweist;
Figur 6 Darstellung mit Abhängigkeiten der Winkel mit denen Lichtstrahlung in Abhängigkeit ihrer jeweiligen Wellenlänge aus dem Substrat einer OLED austritt (links), in ein Substrat mit SPR- oder BSW-Sensor eintritt (mitte), und von einem Detektor mit optische Element erfasst wird (rechts);
Figur 7 ein Beispiel einer erfindungsgemäßen Anordnung mit zwei SPR-Sensoren, deren Schichten mit dispergierter Lichtstrahlung, die von einer OLED mit einem Mehrschichtsystem emittiert worden ist, bestrahlt und von dort reflektierte immer noch dispergierte Lichtstrahlung zur ortsaufgelösten Messung auf ein Detektorarray gerichtet ist, wobei der unten angeordnete SPR-Sensor ohne Probe oder mit bekannter Probe eine Referenz bilden kann;
Figur 8a-c Beispiele für mögliche Ausbildungen einer erfindungsgemäßen Anordnung mit SPR- oder BSW-Sensor;
Figur 9 Diagramme der Abhängigkeit von Winkeln dispergierter Lichtstrahlung die von der Lichtquelle in ein Substrat austritt (rechts) und die Reflexion aus dem Substrat heraus (links) bei einem SPR-Sensor;
Figur 10 in schematischer Darstellung den Aufbau einer bei der Erfindung einsetzbaren OLED mit Mehrschichtsystem, die in Verbindung mit einem SPR-Sensor einsetzbar ist (z.B. entsprechend Fig. 6, 7 oder 8) und ein Diagramm der mit einem Detektor erfassbaren relativen Intensitäten in Abhängigkeit von Winkeln der dispergierten Lichtstrahlung an einem Substrat bei verschiedenen optischen Brechungsindizes einer zu untersuchenden wässrigen Lösung, als Probe;
Figur 11 in schematischer Form ein Beispiel einer OLED mit einem Mehrschichtsystem, die mit einem BSW-Sensor, der ein Schichtsystem, wie es ebenfalls gezeigt ist, aufweist, einsetzbar ist (z.B. entsprechend Fig. 6, 7 oder 8) und ein Diagramm der mit einem Detektor erfassbaren relativen Intensitäten in Abhängigkeit von Winkeln der dispergierten Lichtstrahlung an einem Substrat bei verschiedenen optischen Brechungsindizes einer zu untersuchenden wässrigen Lösung als Probe; und

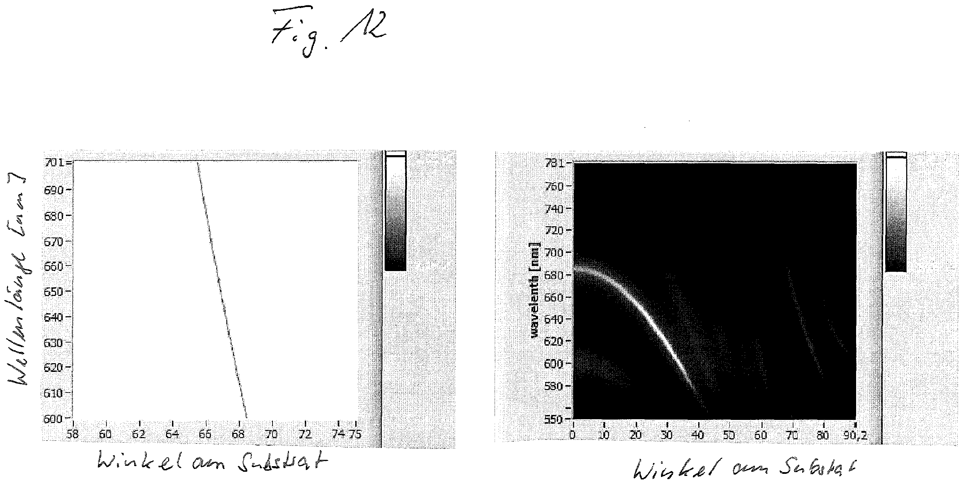

Figur 12 Diagramme der Abhängigkeit von Winkeln dispergierter Lichtstrahlung, die von der Lichtquelle in ein Substrat austritt (rechts) und die Reflexion aus dem Substrat heraus (links) bei einem BSW-Sensor.

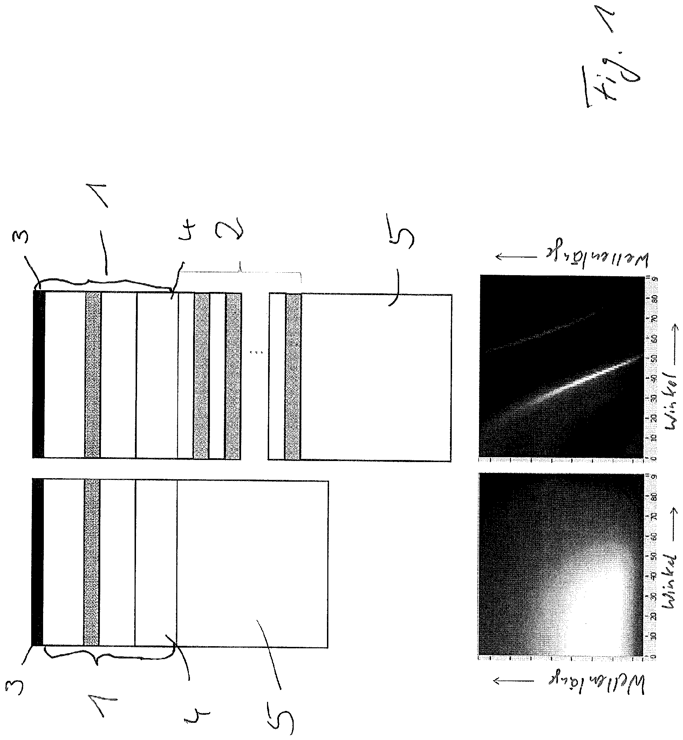

Figur 1 zeigt beispielhaft eine "normale" OLED 1 sowie eine OLED 1 mit einem dielektrischen Mehrschichtsystem 2. Durch die Einführung des Mehrschichtsystems 2, bei dem Schichten mit kleinerem und größeren optischen Brechungsindex übereinander gestapelt angeordnet sind, kann die Lichtemission dramatisch verändert werden. Man erhält im Beispiel eine nahezu lineare Beziehung zwischen emittierten Wellenlängen und den Winkeln in denen Lichtstrahlung mit unterschiedlichen Winkeln, beispielhaft je nach Wellenlänge λ1, λ2, λ3 emittiert wird. Dabei ist das Mehrschichtsystem 2 zwischen der Anode 4 und dem Substrat 5 der OLED ausgebildet. In nichtdargestellter Form kann zusätzlich zum substratseitigen Mehrschichtsystem ein Mehrschichtsystem an der Kathodenseite der OLED angeordnet sein, um das Strahlungsfeld analog zu beeinflussen. Die Kathode 3 muss in diesem Fall aus einem für die jeweils emittierte Lichtstrahlung ausreichend transparenten Material sein. Eine solche Ausführung kann für gleichzeitige unterschiedliche Messungen oder für die Durchführung einer Referenzmessung genutzt werden. Die beiden Mehrschichtsysteme 2 müssen nicht identisch sein. So können mit den Mehrschichtsystemen 2 jeweils gleiche Wellenlängen mit jeweils unterschiedlichen Winkeln emittiert werden, so dass beispielsweise eine Wellenlänge λ1 aus einem Mehrschichtsystem 2 mit dem Winkel θ1 und aus dem anderen Mehrschichtsystem mit dem Winkel θ2 austritt, wobei diese Winkel unterschiedlich groß sind.

Die Eigenschaften des Strahlungsfelds, der emittierten Strahlung hängen von den folgenden Parametern ab:
- Emissionsspektrum des bzw. der verwendeten Emitters in der OLED oder der LED
- Abstand der Emitter von der Kathode (Dicke der ETL Schicht)
- Eigenschaften des dielektrischen Mehrschichtsystems
Durch das Design des Schichtstapels einer OLED 1 in Verbindung mit dem dielektrischen Mehrschichtsystems 2 kann eine Mikrokavität derart aufgebaut werden, dass das sehr breite und Lambert-ähnliche Strahlungsfeld der "normalen" OLED (Figur 1 unten links) drastisch modifiziert wird. In Figur 1 (rechts unten) wird deutlich, dass die Emission von Lichtstrahlung entlang einer Kurve in der Winkel-Wellenlängen-Ebene erfolgt. Dadurch wird die Wellenlänge der Emission aufgrund der Dispersion des Mehrschichtsystems 2 in der Mikrokavität in Verbindung mit dem entsprechenden Mehrschichtsystem mit dem Winkel verknüpft.

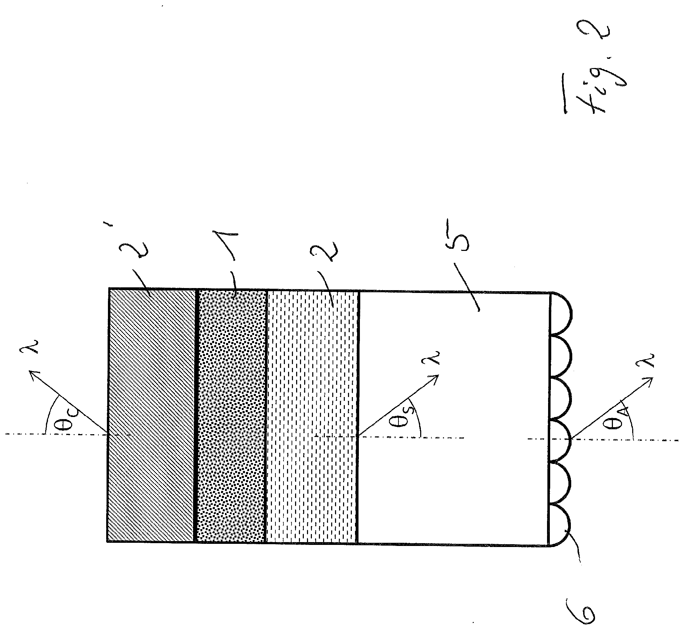

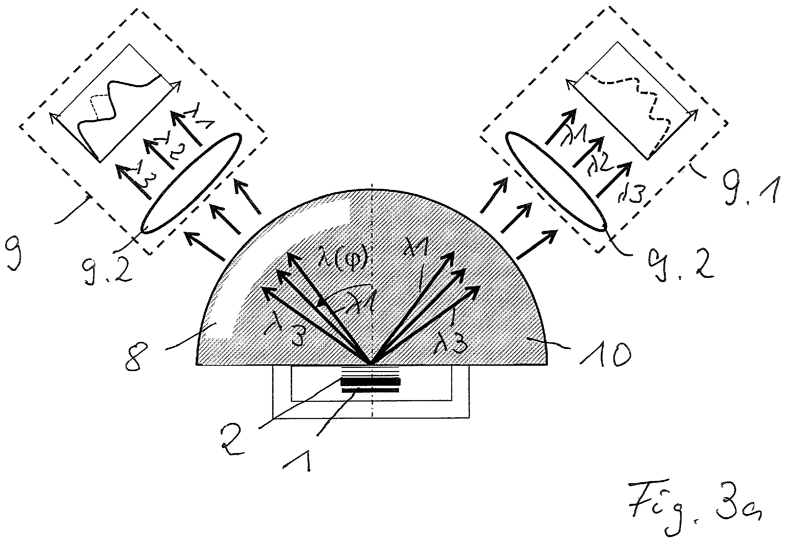

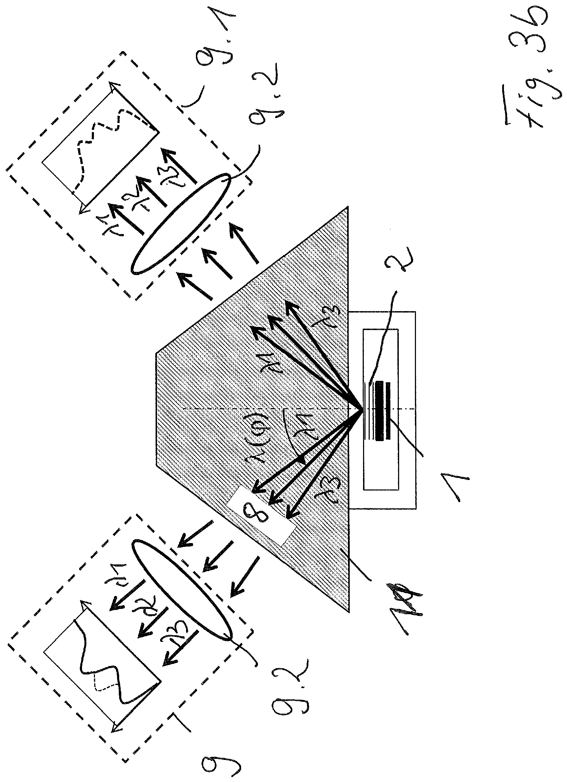

Figur 2 zeigt die verallgemeinerte Struktur einer solchen OLED als Lichtquelle. Dabei kann wie bereits erwähnt, sowohl substratseitig (analog zu Figur 1) als auch kathodenseitig ein Mehrschichtsystem 2' angeordnet sein, um die Emissionseigenschaften gezielt zu modifizieren. Beide Mehrschichtsysteme 2 und 2' müssen natürlich die elektrische Funktionalität und die optischen Eigenschaften, insbesondere das Spektrum der jeweiligen emittierten Lichtstrahlung, der OLED 1 berücksichtigen bzw. dürfen diese nicht stören.
Für die Applikation kann dann entweder das emittierte Strahlungsfeld
▪ im Substrat, z.B. über die Immersionskopplung mit einer Hablkugel/-Zylinder o.ä. (vgl.Figur 3), oder
▪ in der Luft (Substratseite), ggfs. nach der Auskopplung durch eine mikrooptische Struktur,
▪ in der Luft (Claddingseite).
beeinflusst werden. In Figur 2 ist an einer Oberfläche des Substrats 5 eine mikrooptische Oberflächenstruktur 6 vorhanden oder daran ausgebildet, mit der die austretende Lichtstrahlung mit den Wellenlängen λ1, λ2, λ3 durch optische Brechung zusätzlich in ihrem Austrittswinkel beeinflusst werden kann. So kann eine zusätzliche Winkelspreizung erreicht werden. Eine mikrooptische Oberflächenstruktur 6 können miniaturisierte optische Elemente (z.B. Linsen, Pyramiden, Kegel) oder auch streuende Strukturen sein.

Eine derartige beidseitige Emission kann auch zu Referenzzwecken genutzt werden. Das aktive System kann einen oder mehrere Emitter (OLED oder LED) für Lichtstrahlung enthalten, wobei auch die räumliche Anordnung der Emitter im gesamten Schichtstapel zur Beeinflussung der Winkel der emittierten Lichtstrahlung eingestellt werden kann.

Die Erfindung kann in allen Bereichen eingesetzt werden, in denen spektroskopische Messungen erfolgen sollen. Aufgrund ihres Potenzials zur Miniaturisierung sind dabei jedoch bevorzugt Bereiche zu nennen, in denen vor-Ort Messungen vorgenommen werden. Dies trifft auf die biochemische Analytik für Umwelt-, Lebensmittel-, Veterinär-, und Humandiagnostik zu und kann natürlich auf Bereiche der chemischen Analyse u.v.m. erweitert werden.
In diesem Sinn sollen im Folgenden zwei konkrete Anwendungen beschrieben werden. Die Kombination mit dem oben beschriebenen optischen Aufbau mit einer OLED stellt einen neuen vorteilhaften technologischen Ansatz dar.

Eine Applikation einer solchen OLED 1 ist in Figuren 3a und 3b dargestellt. Dabei wird die Tatsache ausgenutzt, dass unterschiedliche spektrale Komponenten der Lichtstrahlung unter unterschiedlichen Winkeln in das Substrat 5 der OLED 1 emittiert werden. Bringt man nun eine zu analysierende Flüssigkeit 8 (als Probe) in diesen (begrenzten) bestrahlten Winkelbereich, so transmittiert Lichtstrahlung mit unterschiedlichen Wellenlängen an unterschiedlichen Positionen.

Diese Transmission kann durch direkte Anordnung einer CCD oder CMOS Kamera 9 nach Transmission durch die Flüssigkeit 8 gemessen werden. Es ist auch möglich, die Kamera 9 durch ein auf "Unendlich" fokussiertes Objektiv 9.2 zu ergänzen. Aufgrund der Symmetrie des OLED-Strahlungsfelds ist es möglich, um 180° (also in der entgegengesetzten Emissionsrichtung) versetzt eine Referenzmessung des emittierten Spektrums mit einer weiteren Kamera 9.1 vorzunehmen und damit die gemessenen Werte zu korrigieren.

Wie aus den beiden Darstellungen der Figuren 3a und 3b deutlich wird, kann der die Flüssigkeit 8 (Probe) führende Kanal auf einem Halbzylinder / Halbkugel (Figur 3a) 10 oder auf einer Oberfläche eines optischen Prisma 11 (Figur 3b) angeordnet werden. Die zuerst genannte Möglichkeit hat den Vorteil, dass weniger optische Brechungseffekte an den Grenzflächen auftreten. Das Prisma 11 ist technologisch leichter herzustellen, wobei abhängig vom Wellenlängen- und Winkelbereich das optische Brechungsgesetz an den verschiedenen Grenzflächen berücksichtigt werden muss.

Als Material der Halbkugel / Halbzylinder / Prisma 10, 11 kann Glas oder auch Polymer eingesetzt sein. Die OLED 1 kann direkt auf dieses Material abgeschieden werden oder durch Immersionsflüssigkeit daran gekoppelt werden. Abhängig vom Design der OLED 1 kann auch ein Luftspalt zwischen dem Substrat 5 der OLED 1 und der Halbkugel / Halbzylinder / Prisma 10, 11 mit der Probe 8 angeordnet sein.

Als Sensoren können beispielhaft SPR- (surface plasmon resonance) oder BSW-Sensoren 12 (Bloch surface waves) verstanden werden. Diese Sensoren 12 beruhen auf der Beobachtung der "Resonanz", die bei der Reflexion an einer Dünnschicht aus Metall (SPR) oder dielektrischen Schichten (BSW) 12.1 beobachtet wird. Nun hat diese Resonanz eine Dispersion, d.h. eine konkrete Beziehung zwischen Winkel und Wellenlänge, die durch die Materialien und Schichtdicken der/des jeweiligen Schicht/Schichtsystems 12.1 eines solchen Sensors 12 vorgegeben ist. Es kann eine niedrige Reflexion an einem SPR- und BSW-Sensor beobachtet werden. Als Messsignal wird eine Verschiebung des Minimums der Reflexion beobachtet. Diese Verschiebung erfolgt entlang eines Vektors S.

Die Lichtstrahlung sollte dabei unter Berücksichtigung der unterschiedlichen Winkel für die unterschiedlichen Wellenlängen λ1, λ2 und λ3 möglichst unter Einhaltung von Totalreflexionsbedingungen (TIR) auf die Schicht oder das Schichtsystem 12.1 gerichtet werden.

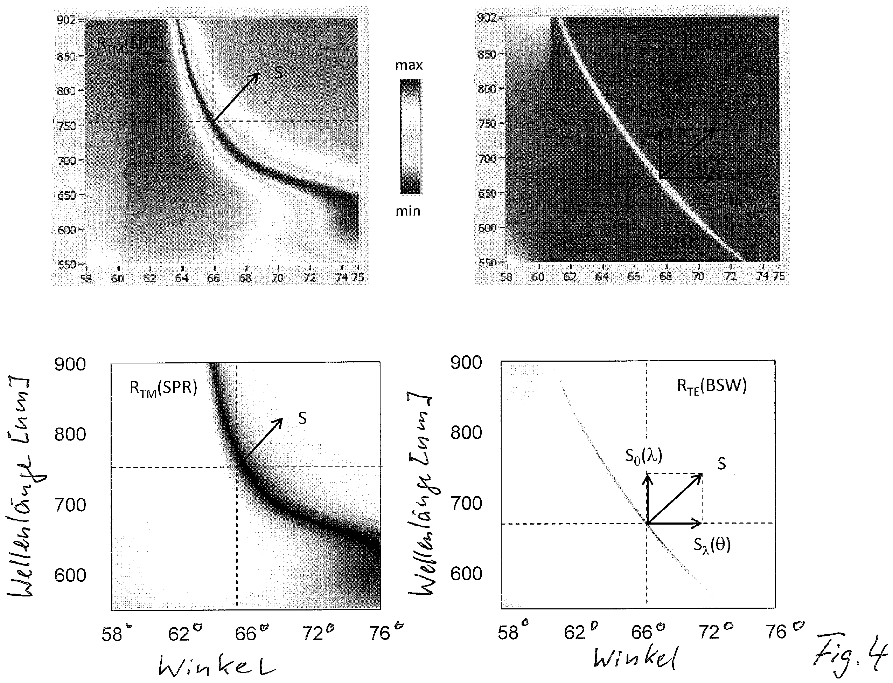

Messtechnische Ansätze zur Auswertung dieser Resonanzen bestehen in
i. Monochromatischer winkelaufgelöster Messung, also Beobachtung eines Schnittes entlang der Richtung S_{λ}(θ) in Figur 4, oder
ii. Spektral aufgelöste Messung bei festem Winkel entlang des Schnittes S_{θ}(λ) in Figur 4, oder
iii. Beobachtung von Intensitätsvariationen bei vorgegebenem Winkel und vorgegebener Wellenlänge.
Problematisch ist, dass die Messansätze (i) und (ii) darauf beruhen, dass das Wellenlängen- oder das Winkelspektrum enorm beschränkt wird, um möglichst schmale Resonanzen auswerten zu können. Dadurch wird aber nur die Projektion der Resonanzverschiebung auf die Winkel- oder Wellenlängenachse in Figur 4 beobachtet.

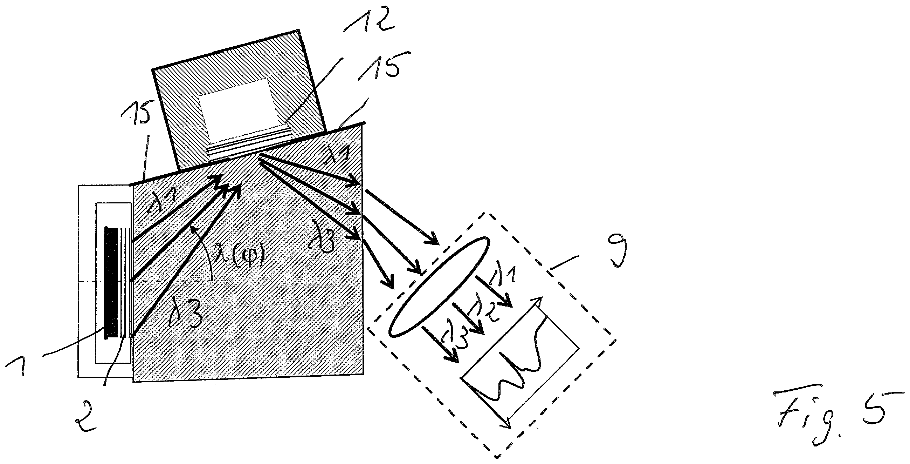

Dieser Effekt könnte reduziert werden, wenn man eine OLED 1 oder eine LED als Lichtquelle mit einer Dispersion entlang der Verschiebung der Resonanz (Vektor S in Figur 4) nutzen würde. Dies kann mit dem Ansatz nach Figur 1 durch eine Anordnung entsprechend Figur 5 erreicht werden. Dort kann aufgrund der Dispersion der Lichtquelle die Sensoroberfläche mit einem ausgedehnten Spektrum der geforderten Dispersion beleuchtet werden. Man beachte, dass der Winkel zwischen OLED 1 als Lichtquelle und Sensor 9, 12 von 90° verschieden sein kann. Die Detektion erfolgt mit einer Kamera 9 mit oder ohne Objektiv analog zu Figur 3a oder 3b.

Die Anordnung nach Figur 5 hat den Nachteil, dass unterschiedliche spektrale Komponenten von unterschiedlichen Bereichen der OLED 1 als Lichtquelle ausgewertet werden. Andere Komponenten des Strahlungsfelds müssen durch eine absorbierende Blende 15 unter dem Schichtsystem 12.1 des Sensors 12 unterdrückt werden.

Der vorab beschriebene Lösungsweg mit dem Einsatz der orts- und wellenlängenaufgelöst erfassenden Kamera 9 hat den Vorteil, dass spektroskopische Untersuchungen nicht auf ein komplexes opto-elektronisches Gerät (Spektrometer) auf der Basis eines Gitters oder Prismas angewiesen sind. Vielmehr wird durch die OLED 1 als Lichtquelle eine definierte Winkel - Wellenlänge - Beziehung vorgegeben, so dass winkelaufgelöste optische Abbildungen automatisch einer spektralen Auflösung entsprechen.

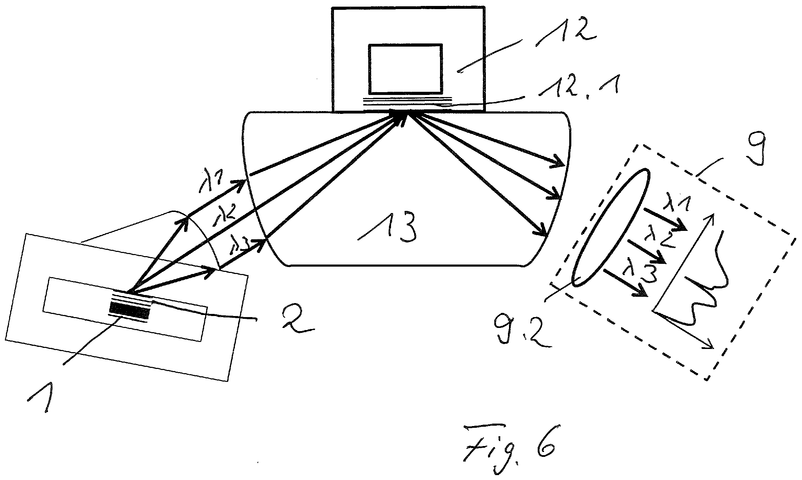

In Figur 6 ist ein Beispiel mit einem Sensor 12 gezeigt. Dabei wird Lichtstrahlung von einer in einem Gehäuse aufgenommenen OLED 1 emittiert. Dabei ist ein Teil des Gehäuses als optisches Element mit konvexer Oberfläche ausgebildet, so dass die Lichtstrahlung, die von der OLED 1 emittiert und mit dem darauf angeordneten Mehrschichtsystem 2 in einzelne Wellenlängen mit unterschiedlichen Austrittswinkeln dispergiert worden ist, als parallele Lichtstrahlung auf eine konvexe Oberfläche eines für die Lichtstrahlung transparenten Körpers 13 auftrifft und damit auf eine Schicht 12.1 eines SPR-Sensors 12 oder ein dielektrisches Schichtsystem12.1 eines BSW-Sensors 12 fokussiert wird. Die an der Schicht 12.1 divergent reflektierte Lichtstrahlung trifft auf eine zweite konvexe Oberfläche des Körpers 13 auf und wird von dort als parallele Lichtstrahlung auf ein Detektorarray 9 gerichtet, so dass die einzelnen Wellenlängen mit ihrer jeweiligen Intensität ortsaufgelöst erfasst und einer Auswertung zugeführt werden können.

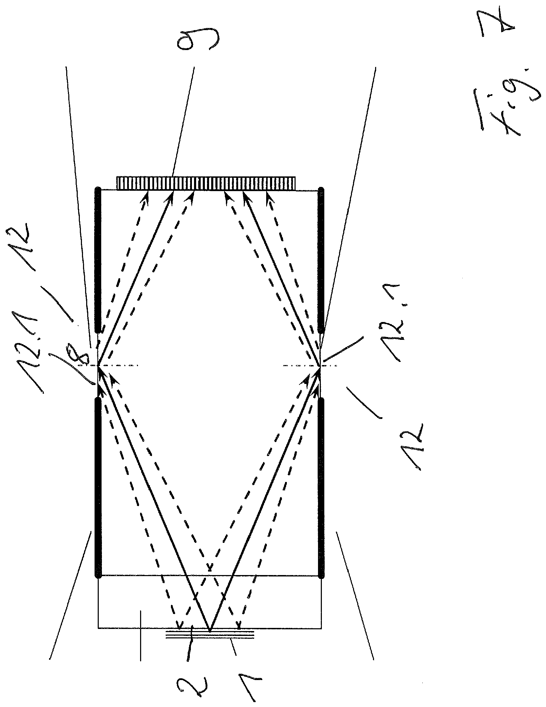

Die Figur 7 zeigt in schematischer Form eine Anordnung mit zwei SPR- oder BSW-Sensoren 12, wobei der oben dargestellte mit einer Probe 8 versehen und zur Messung genutzt werden kann. Der unten angeordnete SPR-Sensor 12 kann für eine Referenzmessung genutzt werden. Dabei wird die von einer OLED 1 emittierte und mit einem Mehrschichtsystem 2 beeinflusste Lichtstrahlung so auf eine Schicht 12.1 eines SPR-Sensors 12 gerichtet, so dass Lichtstrahlung verschiedener Wellenlängen mit jeweils unterschiedlichen für die jeweiligen einzelnen Wellenlängen spezifischen Winkeln auftrifft, um Oberflächenplasmonen anzuregen. Auf der Schicht 12.1 kann eine Probe 8 vorhanden sein.

Vom so bestrahlten SPR-Sensor 12 wird Lichtstrahlung wieder analog für die verschiedenen Wellenlängen mit unterschiedlichen Winkeln reflektiert und auf eine orts- und wellenlängenaufgelöst erfassende Kamera 9 oder ein Detektorarray gerichtet. Mit den so erfassten Signalen kann eine analytische Auswertung einer Probe 8 durchgeführt werden.

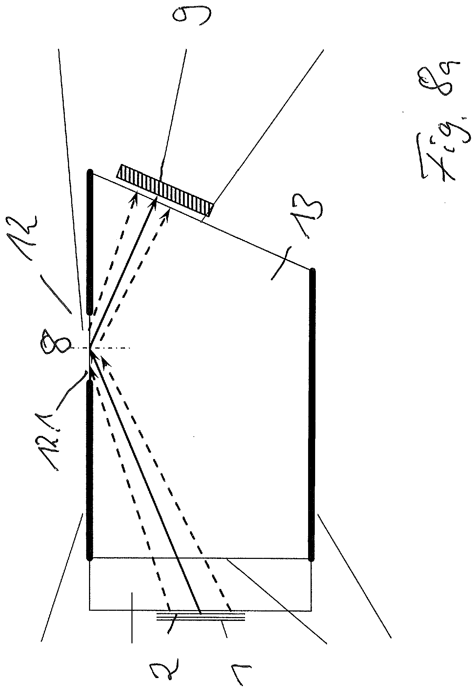

In Figur 8a ist ein weiteres Beispiel für eine Bestimmung an Proben 8 mit einem SPR-Sensor 12 gezeigt. Dabei tritt die von einer OLED 1 emittierte und mit einem Mehrschichtsystem 2 in einzelne unterschiedlich aufgesplittete Lichtstrahlung in einen für die Lichtstrahlung transparenten Körper 13 ein und wird auf eine Schicht 12.1, auf der eine Probe 8 angeordnet sein kann, fokussiert. Diese Lichtstrahlung wird an der Schicht 12.1 reflektiert und sie tritt als divergente Lichtstrahlung aus dem Körper 13 aus, bevor sie auf ein Detektorarray 9 so auftrifft, dass unterschiedliche Wellenlängen der Strahlung an unterschiedlichen für die jeweilige Wellenlänge spezifischen Positionen für eine orts- und wellenlängenaufgelöste Erfassung auftreffen. Diese Anordnung hat den Vorteil, dass der Detektor 9 senkrecht zur Ausbreitungsrichtung der nachzuweisenden Strahlung angeordnet ist.

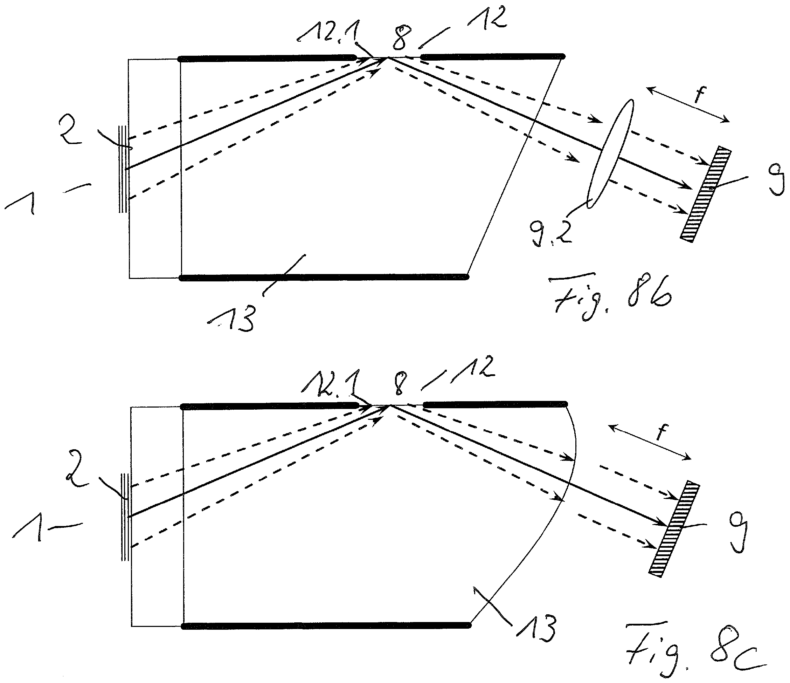

Bei diesem Beispiel kann auch zwischen Körper 13 und Detektorarray 9 eine optische Linse angeordnet sein (Figur 8b), mit der die reflektierte divergente Lichtstrahlung parallelisiert wird, wodurch ein senkrechtes Auftreffen der Lichtstrahlung auf die einzelnen Detektoren des Detektorarrays 9 erreicht werden kann. Dies kann aber auch mit einer konvexen Oberfläche des Körpers 13 aus der die reflektierte Lichtstrahlung in Richtung Detektorarray 12 erreicht werden (Figur 8c).

Für einen SPR-Sensor 12 kann als Schicht 12.1 eine Goldschicht mit einer Dicke im Bereich 45 nm bis 55 nm eingesetzt werden. Die OLED 1 kann Lichtstrahlung im Wellenlängenbereich zwischen 650 nm bis 730 nm emittieren. Dabei kann ein Mehrschichtsystem 2, das abwechselnd aus SiO₂ - und Ta₂O₅-Schichten gebildet sein kann, eingesetzt werden. Dabei werden jeweils zwei alternierende Schichten als Schichtpaar dreimal hintereinander auf einer Substratoberfläche der OLED 1 ausgebildet. Es wird mit einer 263 nm dicken Ta₂O₅-Schicht begonnen, auf der eine 390 nm dicke SiO₂-Schicht ausgebildet wird. Auf diesen Schichtstapel wurde noch eine Schicht aus Ta₂O₅ mit einer Dicke von 263 nm und darauf als äußerste Schicht eine SiO₂-Schicht mit einer Dicke von 169 nm ausgebildet.

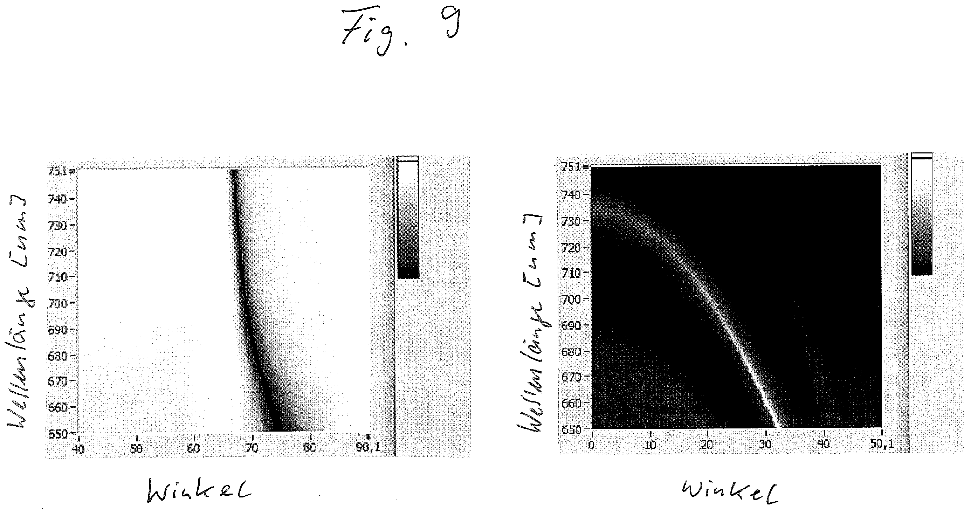

Die Figur 9 zeigt Diagramme mit so erreichbaren Einfallswinkeln von Lichtstrahlung bei unterschiedlichen Wellenlängen sowie die winkel- und wellenlängenaufgelöste Reflexion einer dünnen Goldschicht als SPR Sensor.

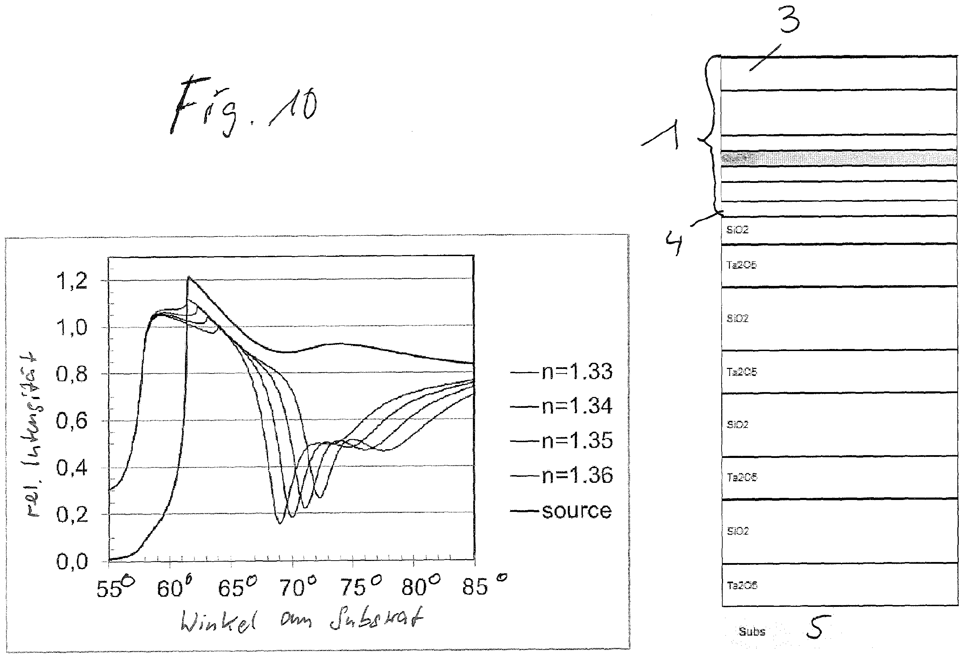

In Figur 10 ist ein Aufbau einer bei einer erfindungsgemäßen Anordnung einsetzbaren OLED 1 mit einem Mehrschichtsystem 2 schematisch dargestellt, wie sie als Lichtquelle für einen SPR Sensor eingesetzt werden kann. Dabei ist das Mehrschichtsystem 2 beispielhaft mit Schichten aus SiO₂ und Ta₂O₅ gebildet. Das Schichtsystems 12.1 des SPR-Sensors 12 besteht aus einer ca. 50 nm dicken Goldschicht (nicht dargestellt). Dieser Sensor hat die in Fig. 9 links dargestellte winkel- und wellenlängenaufgelöste Reflexion. Mit dem Strahlungsfeld einer angepassten OLED 1 (Figur 9 rechts) erhält man die im Diagramm in Figur 10 gezeigten relativen Intensitäten von Lichtstrahlung, die in Abhängigkeit der jeweiligen Wellenlänge nach einer (Total)Reflexion bei verschiedenen Einfallswinkeln auftritt und dementsprechend an verschiedenen Positionen auf ein Detektorarray 9 auftreffen kann. Der oberste Kurvenverlauf entspricht der beobachteten Lichtstrahlung ohne eine SPR Sensorschicht, also bei reiner Totalreflexion der Strahlung am Sensorort 12. Ist eine SPR Sensorschicht 12.1 mit wässriger Lösung, als Probe 8, bedeckt, dann verschiebt sich das Minimum der beobachteten Intensitätsverteilung mit steigendem Brechungsindex dieser Lösung von etwa 68.5° bis zu etwa 72°. Diese Verschiebung des Minimums der Intensitäten kann beobachtet werden, da aufgrund der Dispersion der Lichtstrahlungsenergie die jeweiligen Wellenlänge λ1, λ2 und λ3 nur unter verschiedenen Winkeln emittiert werden (vgl. Vektor S in Fig. 4). Im vorliegenden Beispiel kann beispielsweise ein Mehrschichtsystem 2 aus Ta₂O₅ und SiO₂ eingesetzt werden, das entsprechend der Struktur SiO₂¹⁶⁹|Ta₂O₅|{SiO₂|Ta₂O₅}^{3x}|Substrat 5 aufgebaut ist. Dabei ist die oberste, der OLED 1 zugewandte SiO₂ Schicht 169 nm dick; alle anderen SiO₂ Schichten weisen Dicken von 390 nm und Ta₂O₅ Schichten weisen Dicken von 263 nm auf.

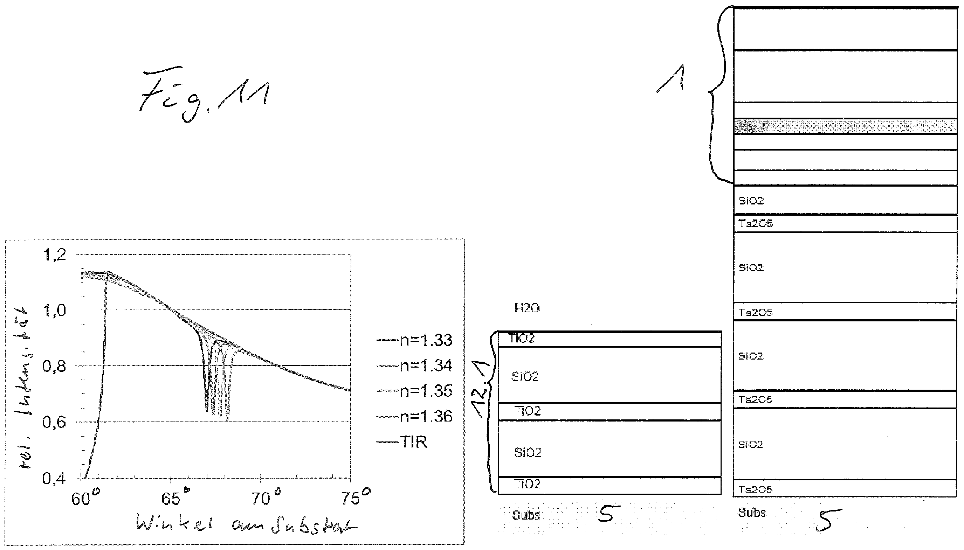

Bei einem BSW-Sensor 12 kann nach Fig. 11 mitte zur Reflexion ein Dünnschichtsystem als Schicht 12.1 eingesetzt werden, das mit einer 95 nm dicken TiO₂-Schicht, die unmittelbar auf dem Substrat der OLED 1 ausgebildet ist, einer darüber ausgebildeten SiO₂-Schicht mit einer Dicke von 300 nm, einem darüber ausgebildeten Schichtpaar, wie das erste Schichtpaar und einer obersten Schicht aus TiO₂ mit einer Dicke von 15 nm gebildet sein. Auf der letzten Schicht kann dann eine Probe 8, insbesondere eine biologische Probe angeordnet werden.

Eine OLED 1 nach Fig. 11 rechts, die Lichtstrahlung im Wellenlängenbereich zwischen 550 nm und 685 nm emittiert, die bei einem BSW-Sensor 12 eingesetzt werden kann, kann mit einem Mehrschichtsystem 2 versehen sein, bei dem auf einer Substratoberfläche drei Paare aus SiO₂- und Ta₂O₅- Schichten mit Schichtdicken von 87 nm für die Ta₂O₅ -Schichten und 340 nm für die SiO₂-Schichten ausgebildet sind. Die erste Schicht auf der Substratoberfläche besteht aus Ta₂O₅. Auf der obersten Schicht dieser drei Schichtpaare ist eine Schicht aus Ta₂O₅ mit einer Dicke von 87 nm und darüber eine Schicht aus SiO₂ mit einer Schichtdicke von 138 nm als oberste Schicht des Mehrschichtsystems 2 ausgebildet.

Der prinzipielle Aufbau ist in Figur 11 gezeigt. Außerdem ist wieder ein Diagramm dargestellt, das dem der Figur 10 entspricht. Der oberste Kurvenverlauf, der einen steilen Anstieg bei ca. 60° Einfallswinkel hat, entspricht dem beobachten Spektrum der OLED 1 nach einer Totalreflexion ohne ein Mehrschichtsystem 2. Erfolgt die Reflexion an einem mit wässriger Lösung bedeckten BSW Sensor (Fig. 11 mitte) dann wird ein lokales Minimum der Reflexion im Bereich zwischen 65° und 70° beobachtet, dessen Lage sich mit steigendem optischen Brechungsindex der wässrigen Lösung analog zur SPR hin zu größeren Winkeln verschiebt. Somit kann auch hier die Verschiebung des Minimums der erfassbaren Intensitäten bei verschiedenen Wellenlängen für eine ortsaufgelöste Bestimmung ausgenutzt werden.

## Patentansprüche

1. Anordnung zur orts- und wellenlängenaufgelösten Erfassung von Lichtstrahlung, die mit mindestens einer OLED oder LED gebildet ist und von der Lichtstrahlung emittiert wird, bei der zwischen einer Elektrode (3, 4), einer OLED (1) oder LED und einem Substrat (5) ein Mehrschichtsystem (2), das mit alternierend übereinander ausgebildeten Schichten aus einem Material mit höherem und niedrigerem optischen Brechungsindex n gebildet ist, angeordnet ist, wobei
von der mindestens einen OLED (1) oder LED Lichtstrahlung mit mehreren unterschiedlichen Wellenlängen λ1, λ2, λ3, ...λn so aus dem Mehrschichtsystem austritt, dass Lichtstrahlung mit unterschiedlichen Wellenlängen λ1, λ2, λ3, ...λn mit definierten Winkeln austritt und nach mindestens einfacher Brechung an einem optischen Element (10, 11), das eine optische Linse (10) oder ein Prisma (11) ist, die/das integraler Bestandteil eines Substrats (5) der OLED (1) oder der LED, mittels einer Immersionsflüssigkeit mit dem Substrat (5) verbunden oder in einem Abstand zum Substrat (5) mit einem dazwischen vorhandenen Spalt angeordnet ist; oder die Lichtstrahlung mit den unterschiedlichen Wellenlängen λ1, λ2, λ3, ...λn auf einen surface plasmon resonance (SPR) - oder Bloch surface waves (BSW)- Sensor (12), der mit einer Schicht oder einem Dünnschichtsystem (12.1) gebildet ist, gerichtet ist, der die Lichtstrahlung mit den unterschiedlichen Wellenlängen λ1, λ2, λ3, ...λn reflektiert; und die Lichtstrahlung durch eine für die Lichtstrahlung zumindest teilweise transparente Probe (8) gerichtet ist und nach der mindestens einfachen Brechung an dem optischen Element, oder Reflexion an einer Schicht oder einem Schichtsystem (12.1) des Sensors (12), auf mindestens ein Detektorarray (9, 9.1), so auftrifft, dass Lichtstrahlung mit einer Wellenlänge λ1, λ2, λ3, ... oder λn auf jeweils ein Detektorelement des Detektorarrays (9, 9.1) auftrifft und die Detektorelemente des Detektorarrays (9, 9.1) diskret zueinander angeordnet sind.

2. Anordnung nach Anspruch 1, **dadurch gekennzeichnet, dass** auf der Oberfläche des Substrates (5) an der die von einer OLED (1) oder LED emittierte Lichtstrahlung austritt, eine mikrooptische Oberflächenstruktur (6) ausgebildet oder dort vorhanden ist.

3. Anordnung nach einem der vorhergehenden Ansprüche, **dadurch gekennzeichnet, dass** Lichtstrahlung jeweils eines Winkels auf ein entsprechend angeordnetes definiertes Detektorelement des Detektorarrays (9, 9.1) auftrifft, so dass aufgrund der Eigenschaften der Lichtquelle die jeweilige Intensität von Lichtstrahlung der entsprechenden Wellenlängen λ1, λ2, λ3, ... λn messbar ist.

4. Anordnung nach einem der vorhergehenden Ansprüche, **dadurch gekennzeichnet, dass** ein zweites Detektorarray (9.1) vorhanden ist, das bevorzugt für eine Referenzmessung nutzbar ist.

5. Anordnung nach Anspruch 5, **dadurch gekennzeichnet, dass** zwei Detektorarrays (9, 9.1) winkelsymmetrisch in Bezug zu einer Achse oder Ebene angeordnet sind.

6. Anordnung nach einem der vorhergehenden Ansprüche, **dadurch gekennzeichnet, dass** oberhalb einer für die emittierte Lichtstrahlung transparente zweite Elektrode (3 oder 4) ein zweites Mehrschichtsystem (2) angeordnet ist, so dass von dort emittierte dispergierte Lichtstrahlung, bei der unterschiedliche Wellenlängen λ1, λ2, λ3, ... λn mit unterschiedlichen Winkeln emittiert werden, auf mindestens ein weiteres Detektorarray (9, 9.1) auftrifft.

## Claims

1. An arrangement for the spatially resolved and wavelength resolved detection of light radiation that is formed by at least one OLED or LED and from which the light radiation is emitted in which a multilayer system (2) is arranged between an electrode (3, 4), an OLED (1) or LED and a substrate (5), said multilayer system being formed by layers formed alternately above one another from a material having a higher and a lower optical refractive index n, wherein
light radiation from the at least one OLED (1) or LED having a plurality of different wavelengths λ1, λ2, λ3, ...λn exits the multilayer system such that light radiation having different wavelengths λ1, λ2, λ3, ...λn exits at defined angles; and,
after an at least simple refraction at an optical element (10, 11) that is an optical lens (10) or a prism (11) that is an integral component of a substrate (5) of the OLED (1) or of the LED, is connected to the substrate (5) by means of an immersion fluid or is arranged at a spacing from the substrate (5) with a gap present therebetween; or
the light radiation having the different wavelengths λ1, λ2, λ3, ...λn is directed onto a surface plasmon resonance (SPR) sensor or Bloch surface wave (BSW) sensor (12) that is formed with a layer or with a thin film system (12.1) and that reflects the light radiation having the different wavelengths λ1, λ2, λ3, ...λn; and
the light radiation is directed through a sample (8) that is at least partly transparent for the light radiation and, after at least the simple refraction at the optical element or reflection at a layer or at a layer system (12.1) of the sensor (12), is incident onto at least on detector array (9, 9.1) such that light radiation having a wavelength λ1, λ2, λ3, ...λn is incident onto a respective detector element of the detector array (9, 9.1) and the detector elements of the detector array (9, 9.1) are arranged discretely from one another.

2. An arrangement in accordance with claim 1, **characterized in that** a microoptical surface structure (6) is formed or is present on the surface of the substrate (5) at which the light radiation emitted from an OLED (1) or from an LED exits.

3. An arrangement in accordance with one of the preceding claims, **characterized in that** light radiation of a respective angle is incident onto a correspondingly arranged defined detector element of the detector array (9, 9.1) such that the respective intensity of light radiation of the corresponding wavelengths λ1, λ2, λ3, ... An is measurable due to the properties of the light source.

4. An arrangement in accordance with one of the preceding claims, **characterized in that** a second detector array (9.1) is present that is preferably usable for a reference measurement.

5. An arrangement in accordance with claim 5, **characterized in that** two detector arrays (9, 9.1) are arranged with angular symmetry with respect to an axis or plane.

6. An arrangement in accordance with one of the preceding claims, **characterized in that** a second multilayer system (2) is arranged above a second electrode (3 or 4) transparent for the emitted light radiation such that dispersed light radiation emitted from there in which different wavelengths λ1, λ2, λ3, ... An are emitted at different angles is incident onto at least one further detector array (9, 9.1).

## Revendications

1. Ensemble de détection avec résolution de position et de longueur d'onde d'un rayonnement lumineux, qui est formé avec au moins une OLED ou LED et à partir duquel est émis le rayonnement lumineux, dans lequel, entre une électrode (3, 4), une OLED (1) ou LED et un substrat (5), il est disposé un système multicouche (2) qui est formé avec des couches superposées constituées en alternance en matériau ayant un indice de réfraction optique n plus élevé et plus faible,
un rayonnement lumineux de l'OLED (1) ou LED au moins au nombre de un sortant du système multicouche avec plusieurs différentes longueurs d'onde λ1, λ2, λ3, ... An de telle sorte que le rayonnement lumineux avec différentes longueurs d'onde λ1, λ2, λ3, ... An sort avec des angles définis et, après au moins une réfraction simple sur un élément optique (10, 11) qui est une lentille optique (10) ou un prisme (11) qui est un élément intégrant d'un substrat (5) de l'OLED (1) ou de la LED, est raccordé au substrat (5) au moyen d'un liquide d'immersion ou est disposé à distance du substrat (5) avec un interstice en position intermédiaire ; ou
le rayonnement lumineux avec les différentes longueurs d'onde λ1, λ2, λ3, ... An est dirigé vers un capteur (12) surface plasmon resonance (SPR) ou Bloch surface waves (BSW) qui est formé avec une couche ou un système à couche mince (12.1) qui réfléchit le rayonnement lumineux avec les différentes longueurs d'onde λ1, λ2, λ3, ... λn ; et
le rayonnement lumineux est dirigé à travers une éprouvette (8) au moins partiellement transparence au rayonnement lumineux et, après la réfraction simple au moins sur l'élément optique ou après la réflexion sur une couche ou un système de couche (12.1) du capteur (12) sur au moins un réseau de détecteurs (9, 9.1), sort de telle sorte que le rayonnement lumineux avec une longueur d'onde λ1, λ2, λ3, ... ou λn heurte respectivement un élément de détecteur du réseau de détecteurs (9, 9.1), et les éléments de détecteur du réseau de détecteurs (9, 9.1) sont disposés de façon discrète les uns par rapport aux autres.

2. Ensemble selon la revendication 1, **caractérisé en ce que**, sur la surface du substrat (5) sur laquelle sort le rayonnement lumineux émis par une OLED (1) ou LED, une structure superficielle (6) micro-optique est constituée ou est présente à cet endroit.

3. Ensemble selon l'une des revendications précédentes, **caractérisé en ce qu'**un rayonnement optique de respectivement un angle heurte un élément de détecteur du réseau de détecteurs (9, 9.1) défini disposé en conséquence de telle sorte que, du fait des caractéristiques de la source lumineuse, l'intensité respective du rayonnement lumineux des longueurs d'onde λ1, λ2, λ3, ... λn correspondantes peut être mesurée.

4. Ensemble selon l'une des revendications précédentes, **caractérisé en ce qu'**il existe un deuxième réseau de détecteurs (9.1) qui peut être utilisé de préférence pour une mesure de référence.

5. Ensemble selon la revendication 5, **caractérisé en ce que** deux réseaux de détecteurs (9, 9.1) sont disposés avec une symétrie angulaire par rapport à un axe ou un plan.

6. Ensemble selon l'une des revendications précédentes, **caractérisé en ce que**, au-dessus d'une deuxième électrode (3 ou 4) transparente au rayonnement lumineux émis, il est disposé un deuxième système multicouche (2) de telle sorte qu'un rayonnement lumineux dispersé émis à partir de là, pour lequel différentes longueurs d'onde λ1, λ2, λ3, ... λn avec différents angles sont émises, heurte au moins un autre réseau de détecteurs (9,9.1).
